# EUROPEAN PATENT APPLICATION

(11) **EP 1 117 127 A1**
(43) Date of publication of application: **18.07.2001**
(21) Application number: 00100852.3
(22) Date of filing: 17.01.2000
(51) Int. Cl.: H01L 21/00

(54) **Arrangement for supporting disklike objects in a processing system**

(71) Applicant: Infineon Technologies AG, 81541 München (DE); Semiconductor 300 GmbH & Co. KG, 01074 Dresden (DE); MOTOROLA, INC., Schaumburg, IL 60196 (US)
(72) Inventor: Kürner, Wolfgang, 01471 Radeburg (DE); Storbeck, Olaf, 01936 Königsbrück (DE); Tucker, Michael Thomas, 01277 Dresden (DE)
(74) Representative: Hermann, Uwe, Dipl.-Ing.

(57) **Abstract**

It is described an arrangement for supporting disklike objects such as wafers, flat panels or CDs in a processing system, particularly in a high-temperature-processing-system. Said arrangement (10) comprises a supporting device (20) for holding an object (11), said supporting device (20) comprising at least one supporting area (21) at least a portion of which forming a connecting surface (22) for said object (11). In order to minimize defects on said object (11) caused by said suppporting device (20), said at least one portion forming said connecting surface (22) is exhibited with a curved, advantageously spherical shape. Supporting device (20) can be provided with a number of support pins (30) having a mushroom configuration, a number of support teeth or a supporting ring.

## Description

The present invention relates to an arrangement for supporting disklike objects such as wafers, flat panels or CDs in a processing system, particularly in a high-temperature-processing-system, said arrangement comprising a supporting device for holding said object, said supporting device comprising at least one supporting area at least a portion of which forming a connecting surface for said object.

In the technical field of manufacturing and processing disklike objects such as wafers, for example disks on the basis of silicon, flat panels, CDs or the like in semiconductor industries it is common and necessary that those objects are frequently moved between different processing stations. Within these processing stations, for example processing chambers, said objects are subjected to different treatments. Some of these treatments are performed under high temperature conditions in high-temperature-processing-systems, an example of which being a RTP system (Rapid Thermal Processing System). During a treatment within a processing station the objects are supported by special supporting devices.

It is known in the art to use supporting devices including three or more support pins. Such a device is disclosed in EP-A-0 877 414. According to the teachings of said document each support pin comprises a supporting area a portion of which forming a connecting surface for said object. The object to be treated is positioned on the connecting surface of each support pin, for example on the top end of each supporting pin.

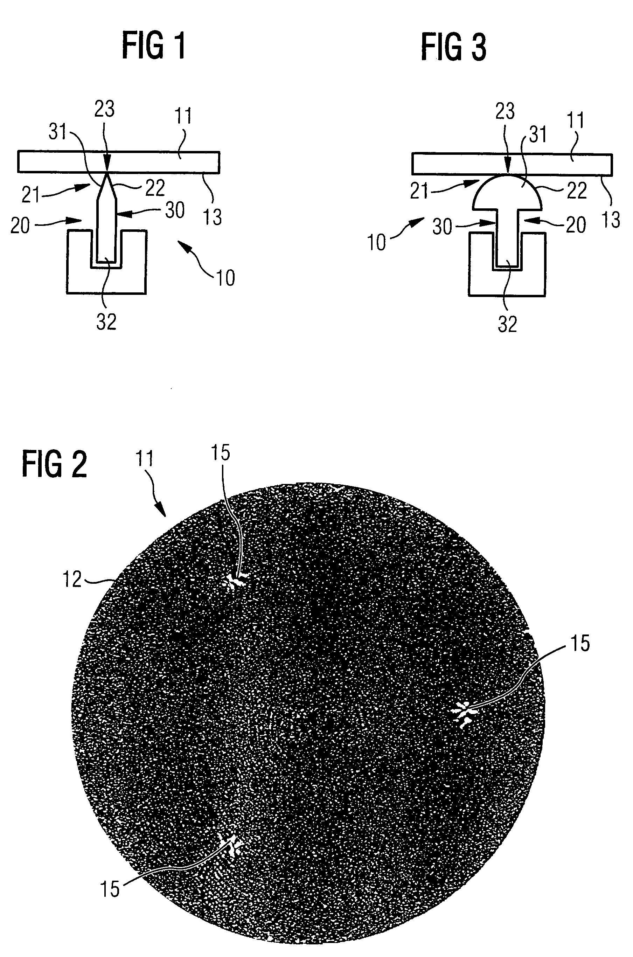

An example for a known support pin is described with respect to Figure 1.

Nevertheless, such support devices using support pins as known in the art show severeal drawbacks. Especially in high-temperature-systems those known support pins, which have sharp edges at their top ends and therefore in the area of its connecting surfaces, can cause crystal defects (slips) on the object which affect significant areas of the object's surface. Examples for such defects are described below with respect to Figure 2.

The area influenced by those slips increases with increasing process temperature and process time. Once created, the defect can grow with every thermal treatment of the object.

The origin of these defects can be described as micro-indentation marks of the support pins. The stress caused by the object's weight can reach several Mpa at every support point. A support point is such a point at which the support pin gets in direct contact with a surface of the object to be supported. This is sufficient to create dislocatios at elevated temperatures.

Another type of defect might arise upon the effect that the object usually expands during the rise of temperature. Thus, the support pins can cause scratches on the object's surface. These scratches can then later form dislocations when a temperature sufficient to create such dislocations is reached.

For the above reasons a necessity exists to control or avoid such a defect formation by hardware and process conditions.

According to another known solution, so called supporting rings are used as supporting devices for supporting disklike objects. An example for such a supporting ring is disclosed in EP-A-0 703 606. This supporting ring is used to press and hold an object (a wafer) onto a pedestal. The support ring includes several support teeth which extend from the ring body in a direction towards the center of said support ring. Therefore, the object to be treated comes into contact with the edges of said support ring as well as those edges of said support teeth. These edges, however, have sharp edges. Only one edge is described as being possibly rounded or tilted, namely the edge provided at the top end of the support tooth. However, said edge does not support the object. The reason for the rounded edge as disclosed in EP-A-0 703 606 is to improve the flow of a process gas.

Supporting devices with such supporting rings create a different defect pattern. The supporting ring -based on its sharp edges- causes a thermal gradient during heat treatment of the object, said thermal gradient leading to the formation of defects (slips) at the edge of said object. A typical slip map is shown in Figure 5. The entire edge of the object is covered with these defects.

A further contribution to the slip defect problem arises due to the gravitational effects from the weight of the object itself and from the location of the support points. Different spacing and placement could influence the strength of the defects (slip).

In view of the prior art it is an object of the present invention to provide an arrangement for supporting disklike objects which overcomes the aforementioned drawbacks.

This object is solved by the arrangement according to independent claim 1. Further advantages, features, aspects and details of the invention become evident from the dependent claims, the description and the accompanying drawings.

According to the present invention, an arrangement for supporting disklike objects such as wafers, flat panels or CDs in a processing system, particularly in a high-temperature-processing-system, is provided, said arrangement comprising a supporting device for holding said object, said supporting device comprising at least one supporting area at least a portion of which forming a connecting surface for said object. Said at least one portion forming said connecting surface exhibits a curved, advantageously spherical shape.

It is the general aspect of the present invention to modify the connecting surface of a supporting device, which comes into contact with the object to be supported, in such a way that the influence of the support device on the creation and growth of defects such as slips can be minimized. The reduction of stress at the object's support points, which causes micro-indentations as mentioned above, can be achieved by an increase of the supporting area, paticularly by an increase of the connecting surface. Therefore, the connecting surface exhibits a curved, advantageously spherical shape. Based on such a configuration it can be achieved that the object is not supported by sharp edges of the support device, but by smooth edges.

The arrangement according to the present invention can be used in combination with different disklike objects. Therefore, the invention is not limited to specific types of objects. Advantageously, the arrangement is used to support disklike objects such as wafers, flat panels or CDs. Particularly, the arrangement is used to support wafers with a diameter up to and beyond 300mm.

In the following, the invention will be described with respect to wafers. However, the invention is not limited to this specific use.

Different arrangements for supportig objects (wafers) require different types of supporting devices. Different embodiments of suitable supporting devices will be described hereinafter without limiting the scope of the invention to these specific examples. The supporting devises can preferably be used to support disklike objects (wafers) within high-temperature-processing-systems such as RTP-Systems.

Preferably, said supporting device comprises a number of support pins, advantageously three or more support pins, the top ends of said support pins forming said supporting area with said connecting surface,respectively. According to this embodiment, the wafer is placed onto the top ends of said support pins. The top end front side of each support pin shows a curved, advantageously sherical shaped surface. Therefore, each support pin does not have any sharp edge which might come into contact with the wafer to be supported. Thus, those defects as described above with respect to the prior art can be avoided or at least minimized. Furthermore, each support pin provides a greater support area (connecting surface) than those support pins as known in the art, which usually have nearly a point-focal or line shaped support area. For that reason, the stress at the wafer support points causing the micro-indentations on the wafer surface can be minimized.

The radius of said curved or spherical shaped connecting surface should be as large as possible for minimal indentation. On the other hand, a large radius could cause a large area of shadowing, which for example is disadvantageous when the wafer is coated by a material. Therefore, an optimized radius has to be determined. In currently used processing systems a radius of about 3mm is deemed to be suitable. Nevertheless, the invention is not limited to any specific radii which might vary with regard to different processing systems and conditions.

Preferably, said support pins might have a mushroom shaped configuration. In this case, the support pins are provided with a pin body that can show a configuration with sharp edges. At the top end of the pin body, a supporting area is provided that area having the shape of a mushroom-head. The curved side of said mushroom headed supporting area forms the curved or spherical shaped connecting surface which is brought into contact with the wafer to be supported.

According to another embodiment of the present invention said supporting device can comprise a supporting ring, said supporting ring comprising a connecting surface being directed towards the center of said supporting ring, said connecting surface exhibiting a curved, advantageously spherical shape.

Preferably, said supporting ring can be formed as an edge ring support. A support ring like that has a substantially annular configuration that surrounds an open inner area. The support ring supports the wafer at its edge.

In order to avoid the appearance of defects based on a thermal gradient or the formation of micro-indentations as described with respect to the prior art, the supporting ring comprises a curved or spherical shaped connecting surface.

Advantageously said connecting surface can be rounded and/or tilted to provide said curved or spherical shape.

According to yet another embodiment of the present invention, the supporting device comprises a number of support teeth, advantageously three or more support teeth, said support teeth supporting said object in such a manner that those portions of said teeth which form a connecting surface for said object exhibit a curved, advantageously spherical shape.

Those supporting teeth preferably extend in parallel to the surface of the object, which is to be supported. In case that a wafer is to be supported, said support teeth extend -from the view of the wafer- from the outer wafer edge in direction towards the wafer center.

In order to avoid gravitational stress, said support teeth support the wafer a few centimeters, for example at a radius of about 0.5 to 0.8 times the radius of the wafer (maybe about three centimeters) inside the wafer, that is a few centimeters from the outer edge of the wafer in direction to the wafer's center. Due to bowing of the wafer under its own weight there result well defined support points. In order to avoid any defects on the wafer as described in view of the prior art, it is necessary to avoid any sharp edges in those areas which support the wafer (support points). In order to get rid of such defects, supporting teeth are provided having a circular or spherical shape in the supporting areas. Therefore, also the connecting surface is provided with such a shape.

Preferably, the connecting surface of a support tooth can be provided by at least a portion of the tooth body. In this case the tooth itself can have a partially or completely rounded configuration.

It is also possible that said connecting surface of a support tooth is provided by the top end of said support tooth. This can be realized by a "ball-shaped" top end of the supporting tooth or the like.

According to another aspect, said connecting surface of a support tooth can be formed by at least one rounded or bevelled edge of said top end and/or of said tooth body.

The radius of this curved or spherical shaped connecting surface should be as large as possible within the constraints of the arrangement or processing system.

Those portions of said support teeth, which form said connecting surfaces, can advantageously be elevated with respect to the other parts of said teeth, the elevation being highter than the maximum bow of said object to be supported. The reason for such a configuration is to avoid a situation in which the wafer edge might touch the support tooth.

In a preferred embodiment, the aforementioned arrangement for supporting disklike objects (wafers) according to the present invention can be arranged within a batch furnace. Such a batch furnace, which per se is known in the art, is equipped with more than a hundred slots for supporting wafers, whereby each wafer is supported by a number of support teeth.

Advantageously, each support pin and/or support tooth forms a supporting point, said supporting point being located at a radius of about 0.5 to 0.8 times the radius of said object, measured from the object's centre. The placement of said supporting points plays a major role with respect to the creation of defects due to the gravitational effects caused by the weight of said disklike object. The aforementioned values for suitable positions of said supporting points represent a preferred embodiment of the present invention. However, the invention is not limited to any concrete example.

Preferably, three support pins and/or support teeth are provided, each support pin and/or support tooth forming a supporting point, said supporting points being spaced with an angle of 120° from each other. This allows a even weight distribution of the wafer.

Moving said supporting points from the wafer edge towards the wafer center together with the 120° spacing dramatically decreases the stress and therefore minimizes the occurance of wafer defects.

Advantageously, said connecting surface can have a roughness which does not exceed the roughness of a surface of said object being supported at said connecting surface. Thus, micro-indentations on the wafer surface can be avoided.

The invention will be better understood by reference to the following description of embodiments of the invention taken in conjunction with the accompanying drawings, wherein:
Figure 1 shows a schematic side view of a support pin of a supporting device according to the prior art;
Figure 2 shows a SIRD (Scanning Infrared Depolarisation) map of a wafer which has been supported by support pins as shown in Figure 1;
Figure 3 shows a schematic side view of a support pin of a supporting device acording to the present invention;
Figure 4 shows a schematic cross sectional side view of a supporting ring of a supporting device according to the prior art;
Figure 5 shows a SIRD (Scanning Infrared Depolarisation) map of a wafer which has been supported by a supporting ring as shown in Figure 4;
Figure 6 shows a schematic cross sectional side view of a supporting ring of a supporting device according to the present invention;
Figure 7 shows a schematic perspective view of a support tooth of a supporting device according to the prior art;
Figure 8 shows a schematic side view of a support tooth of a supporting device acording to a first embodiment of the present invention; and
Figure 9 shows a schematic side view of a support tooth of a supporting device according to another embodiment of the present invention.

The drawings according to Figures 1 to 9 show arrangements 10 for supporting disklike objects 11. In the present examples, said objects 11 are formed as wafers. Said wafers 11 shall be treated under high temperatures in a high-temperature-processing-system, for example a RTP-System. During treatment, said wafers have to be supported by a supporting device 20.

Figure 1 shows an arrangement 10 for supporting wafers 11, which is known in the prior art and which includes a supporting device 20, said device 20 comprising a number of support pins 30. In order to allow an even weight distribution of the wafer 11, three support pins 20 are provided which are spaced with an angle of 120° from each other.

Each support pin 30 includes a pin body 32 and a top end 31. The top end 31 forms a supporting area 21, said supporting area 21 having a connecting surface 22. The wafer 11 is placed with its backside surface 13 onto the connecting surface 22 of each support pin 30. As evident from Figure 1, the supporting area 21 of each supporting pin 30 is formed as a tapered portion the top end of said tapered portion forming a supporting point 23 with a punctual or linear shape. Therefore, wafer 11 is supported by a sharp edged connecting surface 22.

However, such a configuration of support pins 30 has several drawbacks. Such a wafer support can cause crystal wafer defects, which affect significant areas of the wafer surface.

This becomes evident from Figure 2. Figure 2 shows a SIRD (Scanning Infrared Depolarisation) map of wafer 11, which has been suported by three supporting pins 30 according to Figure 1. Figure 2 shows a simulation result after a RTP process performed by 1050°C. The wafer 11 shows three defects 15, which result from said sharp edged connecting surfaces 22 of support pins 30. The area influenced by those defects 15 increases with increasing process temperature and process time. Once created said defects 15 can grow with every thermal treatment of wafer 11.

A practical solution for reducing the influence of said support points 23 of support pins 30 can be found in a new shape of support pins 30. Figure 3 shows a preferred embodiment of such a modified support pin 30. Said support pin 30 has a mushroom shaped configuration consisting of a pin body 32 and a mushroom-head formed top end 31. The top end 31 forms a supporting area 21 a portion of which forms a connecting surface 22 with a spherical shape. Thus, a reduction of stress at the wafer supporting points 23 can be achieved. Such stress is responsible for the defects 15 on wafer surface 13. The radius of said spherical shaped connecting surface should be as large as possible for minimal indentation. The trade-off of a large radius is the larger area of shadowing. In the present embodiment, a radius of 3mm seems to be most favourable.

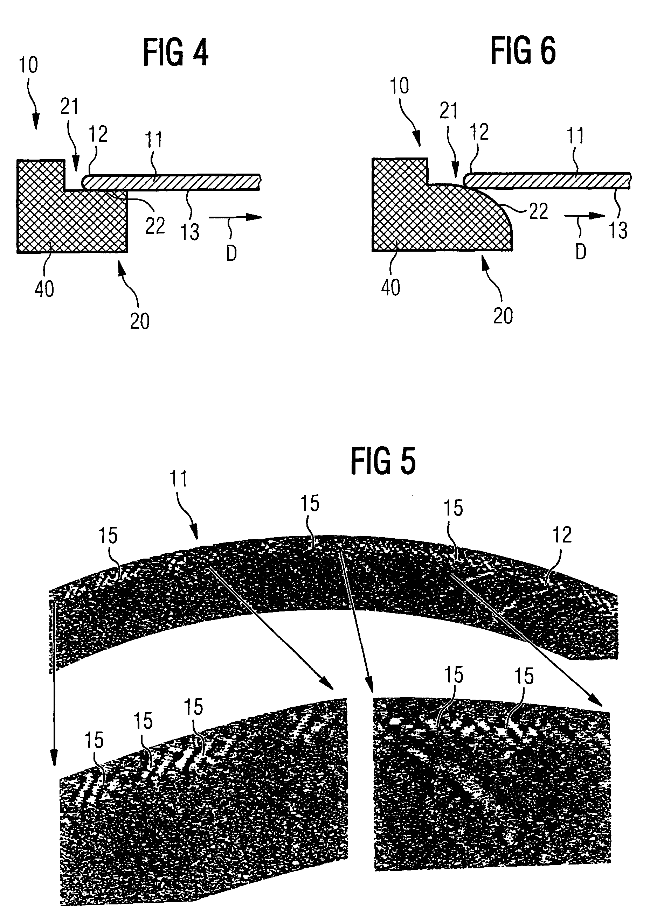

Figures 4 to 6 show another embodiment of the present invention, said embodiment using a supporting ring 40 for supporting wafer 11.

Figure 4 represents a supporting ring 40 which is known in the prior art. Support devices 20 with such a configuration create -based on the sharp edges of supporting ring 40- a defect pattern, which is caused by a thermal gradient. Said thermal gradient leads to defects at the edges 12 of wafer 11. A typical SIRD map of such defects 15 is shown in Figure 5. The whole wafer edge 12 is covered with defects 15. For a better illustration, Figure 5 shows a section of said SIRD map as well as enlarged portions thereof, said enlargements being associated with said "main" SIRD map by arrows respectively.

In order to avoid or at least to minimze such defects 15, supporting ring 40 is advantageously formed in a manner as shown in Figure 6. According to Figure 6, supporting ring 40 comprises a connecting surface 22, said surface 22 being directed towards the center of said supporting ring 40 as indicated by arrow D. Connecting surface 22 is rounded and tilted, thus forming a spherical shape. Based on this configuration a thermal gradient as well as micro-indentations can be minimized.

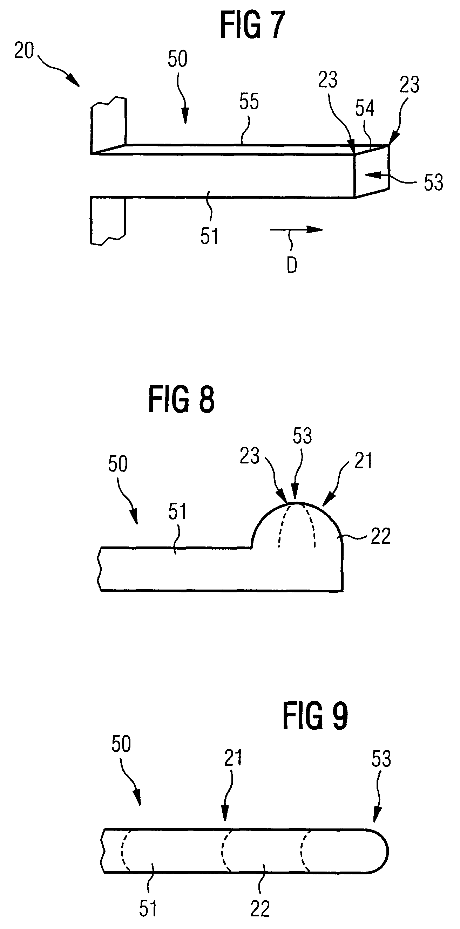

Figures 7 to 9 finally show a third embodiment of the present invention. Said embodiment is based on a supporting device 20 having a number of support teeth 50. In the present case, supporting device 20 is provided with three support teeth 50. For example, such a supporting device can be used in a batch furnace with more than a hundred slots, whereby the wafers 11 are supported by support teeth in every slot. In order to avoid graviatitonal stress, support teeth 50 support the wafer 11 a few centimeters inside the wafer 11, that is a few centimeters apart from wafer edge 12. Thus, said support teeth 50 define supporting points 23, which preferably are located at a radius of about 0.5 to 0.8 times the radius of said wafer 11, measured form the wafer's centre. Preferably, each support tooth 50 can have a length of about 3cm.

A single support tooth 50 as known from the prior art is shown in Figure 7. Due to the bowing of wafer 11 under its own weight there result well defined support points 23. Since these support points 23 define sharp edges 54, 55, they can cause wafer defects 15 as mentioned above.

To get rid of such defects 15 in the areas of sharp edges 54, 55 of support teeth 50, suppport teeth 50 according to Figures 8 and 9 are proposed which have -at least partly- a spherical shaped connecting surface 22.

Figure 8 shows a support tooth 50 according to the present invention, said tooth 50 having a tooth body 51 and a top end 53. Tooth body 51 can be formed in conventional manner. Top end 53 has a spherical shaped connecting surface 22 which is "ball-shaped" in the present example. Wafer 11 is placed with its backside surface 13 onto said connecting surface 22. The radius of this spherical surface 22 should be as large as possible within the constraints of arrangement 10 and the processing system. An additional important item of the design of connecting surface 22 (top end 53) is the fact that it needs to be elevated with respect to the other parts (tooth body 51) of support tooth 50. Supporting point 23 should be higher than the maximum bow from wafer 11 to avoid the wafer edge 12 touching support tooth 50.

Figure 9 shows a support tooth 50 with a completely rounded tooth body 51, tooth body 51 thus forming connecting surface 22 of supporting area 21 of supporting device 20. In this embodiment, also top end 53 is provided with rounded or bevelled edges.

## Claims

1. An arrangement for supporting disklike objects such as wafers, flat panels or CDs in a processing system, particularly in a high-temperature-processing-system, said arrangement (10) comprising a supporting device (20) for holding said object (11), said supporting device (20) comprising at least one supporting area (21) at least a portion of which forming a connecting surface (22) for said object,
**characterized in**
that said at least one portion forming said connecting surface (22) exhibits a curved, advantageously spherical shape.

2. The arrangement according to claim 1,
**characterized in**
that said supporting device (20) comprises a number of support pins (30), advantageously three or more support pins, the top ends (31) of said support pins (30) forming said supporting area (21) with said connecting surface (22),respectively.

3. The arrangement according to claim 2,
**characterized in**
that said connecting surface (22) being spherical shaped having a radius of about 3mm.

4. The arrangement according to claim 2 or 3,
**characterized in**
that said support pins (30) have a mushroom shaped configuration.

5. The arrangement according to claim 1,
**characterized in**
that said supporting device (20) comprises a supporting ring (40), particularly an edge ring support, said supporting ring (40) comprising a connecting surface (22) being directed towards the center of said supporting ring (40), said connecting surface (22) exhibiting a curved, advantageously spherical shape.

6. The arrangement according to claim 5,
**characterized in**
that said connecting surface (22) being rounded and/or tilted to provide said curved, advantageously spherical shape.

7. The arrangement according to claim 1,
**characterized in**
that said supporting device (20) comprises a number of support teeth (50), advantageously three or more support teeth, said support teeth (50) supporting said object (11) in such a manner that those portions of said teeth (50) which form a connecting surface (22) for said object (11) exhibit a curved, advantageously spherical shape.

8. The arrangement according to claim 7,
**characterized in**
that said connecting surface (22) of a support tooth (50) being provided by at least a portion of the tooth body (51).

9. The arrangement according to claim 7 or 8,
**characterized in**
that said connecting surface (22) of a support tooth (50) being provided by the top end (53) of said support tooth (50).

10. The arrangement according to anyone of claims 7 to 9,
**characterized in**
that said connecting surface (22) of a support tooth (50) being formed by at least one rounded or bevelled edge (54; 55) of said top end (53) and/or of the tooth body (51).

11. The arrangement according to anyone of claims 7 to 10,
**characterized in**
that those portions of said support teeth (50), which form said connecting surfaces (22), are elevated with respect to the other parts of said teeth (50), the elevation being higher than the maximum bow of said object (11) to be supported.

12. The arrangement according to anyone of claims 7 to 11,
**characterized in**
that said arrangement (10) being arranged within a batch furnace.

13. The arrangement according to anyone of claims 2 to 4 or 7 to 12, **characterized in**
that each support pin (30) and/or support tooth (50) forms a supporting point (23), said supporting point (23) being located at a radius of about 0.5 to 0.8 times the radius of said object (11), measured from the object's centre.

14. The arrangement according to anyone of claims 1 to 13,
**characterized in**
that three support pins (30) and/or support teeth (50) are provided, each support pin (30) and/or support tooth (50) forming a supporting point (23), said supporting points (23) being spaced with an angle of 120° from each other.

15. The arrangement according to anyone of claims 1 to 14,
**characterized in**
that said connecting surface (22) having a roughness which does not exceed the roughness of a surface (13) of said object (11) being supported at said connecting surface (22).
